# EUROPEAN PATENT SPECIFICATION

(11) **EP 1 156 611 B1**
(45) Date of publication and mention of the grant of the patent: **07.11.2012**
(21) Application number: 01111585.4
(22) Date of filing: 11.05.2001
(51) Int. Cl.: H03J 7/18, H04H 60/43, H03J 1/00

(54) **Receiver comprising a frequency scanning means**
Empfänger mit einem Sendersuchlaufsystem
Récepteur comportant un dispositif de balayage de fréquences

(30) Priority: 19.05.2000 JP 2000148746
(43) Date of publication of application: 21.11.2001
(73) Proprietor: CLARION Co., Ltd., Tokyo (JP)
(72) Inventor: Matsuda, Makoto, Tokyo (JP)
(74) Representative: Eisenführ, Speiser & Partner

(56) References cited:
- US-A- 4 763 195
- US-A- 5 710 992

## Description

The present invention relates to a receiver apparatus having a frequency searching function (referred to also as "seeking", hereinafter) for automatically searching DAB (Digital Audio Broadcasting) of a receivable frequency.

US 5,710,992 shows a method of searching for active signal frequencies from a plurality of frequency bands. Bands of frequencies are defined by upper and lower limit frequencies. The bands are stored as chains in a chain memory. A controller searches for active signal frequencies by sequentially recalling each chain and searching the band of frequencies defined by the upper and lower limit frequencies. Active signal frequencies may be stored in a channel memory.

US 4,763,195 shows a tuning system for tuning non-standard frequency RF television signals provided by cable distribution networks and television accessories. The system conducts first and second consecutive searches by changing the local oscillator frequency. The first search is limited to search frequencies corresponding to predictable non-standard frequencies associated with the major cable distribution networks. The second search includes more search frequencies and extends over a wider frequency range than the first.

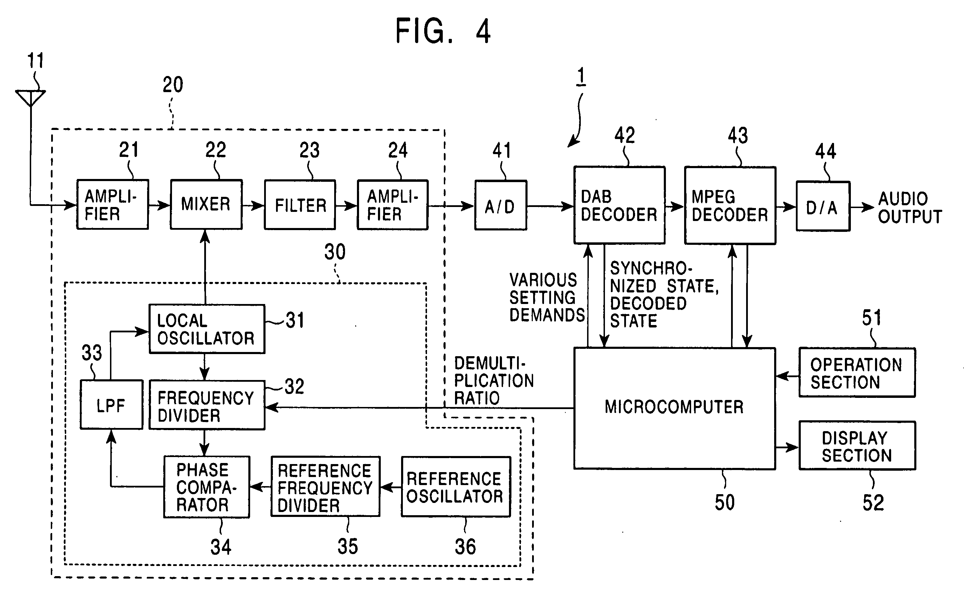

Fig. 4 shows the configuration of a conventional DAB receiver apparatus. The DAB receiver apparatus, generally designated by numeral 1, has an antenna 11 which receives the DAB. A tuner 20 extracts, from among signals received through the antenna 11, a frequency component of a desired frequency and amplifies the extracted frequency component, followed by a frequency conversion into a predetermined intermediate frequency.

The signals of the intermediate frequency, which are still an analog signals, are converted into a digital signal by means of an A/D converter 41. A DAB decoder 42 decodes the DAB from the digital signals of the intermediate frequency. An MPEG audio decoder 43 decodes audio data from the decoded DAM data. The decoded audio data is converted by a D/A converter 44 into analog signals which are output as audio signals.

A microcomputer 50 is responsible for the overall control of the entire DAB receiver apparatus 1. The receiver apparatus 1 has an operation section 1 having various keys which permit entry of user's requests, and a display section 52 which displays the state of the operation.

The tuner 20 has a first amplifier 21 fir amplifying the DAB signals, a mixer 22 for converting the amplified signals into signals of the intermediate frequency, a filter 23 that extracts only the DAB frequency band from the frequency-converted signals of the intermediate frequency, a second amplifier 24 for amplifying the band-limited intermediate-frequency signals, and a PLL (phase synchronous loop) circuit 30.

The mixer 23 performs the frequency conversion of the DAB signals into the signals of the intermediate frequency, by mixing the oscillation signal derived from the PLL circuit with the DAB signals.

The PLL circuit 30 has the following components: a local oscillator 31 for generating an oscillation signal of a desired local oscillation frequency in accordance with a control voltage; a frequency divider 32 for demultiplying, i.e., frequency-dividing, the signal oscillated by the oscillator 31 with a demultiplication factor which is set by the microcomputer 50; a reference oscillator 36 for generating a reference signal; a reference frequency divider 35 for dividing the frequency of the reference signal with a fixed demultiplication factor; a phase comparator 34 for comparing the output signal of the frequency divider 32 with the output signal of the reference frequency divider 35 and for generating a phase difference signal indicative of the phase difference between these two output signals; and an LPF (low-pass filter) which produces a control voltage based on the phase difference signal.

The microcomputer 50 suitably changes the demultiplication factor set on the frequency divider 32 in accordance with the intermediate frequency, in order that the desired intermediate frequency be produced by the mixer 22. This operation performed by the microcomputer will be referred to as "frequency setting", hereinafter.

A system called "seeking system" has been known which is used in the illustrated type of the receiver apparatus and which automatically searches for DAB broadcasting signals receivable by the receiver. The seek system sequentially checks receivable frequencies from different broadcasting stations and, when a frequency component having an electric field intensity greater than a predetermined intensity is detected, terminates the seeking operation to cause the receiver apparatus to receive the detected frequency component, whereby the receiver apparatus is tuned to a specific broadcast station. More specifically, when electric waves from a certain broadcasting station is received through the antenna during the seeking operation, the receiver apparatus processes the received electric wave signals to obtain a received-electric-field intensity signal indicative of the level of the electric field of the received electric wave signals. The receiver apparatus 1 then compares the received-electric-field intensity signal with a predetermined reference voltage. If the received-electric-field intensity signal is greater than the reference voltage, the receiver apparatus 1 stops the seeking operation and starts to receive the broadcast signals from this broadcasting station. Conversely, if the received-electric-field intensity signal is smaller than the reference voltage, the receiver apparatus no more receives the signals from this broadcasting station, and restarts the searching operation and detects the received-electric-field intensity of the signals of the next frequency, i.e., the next broadcasting station.

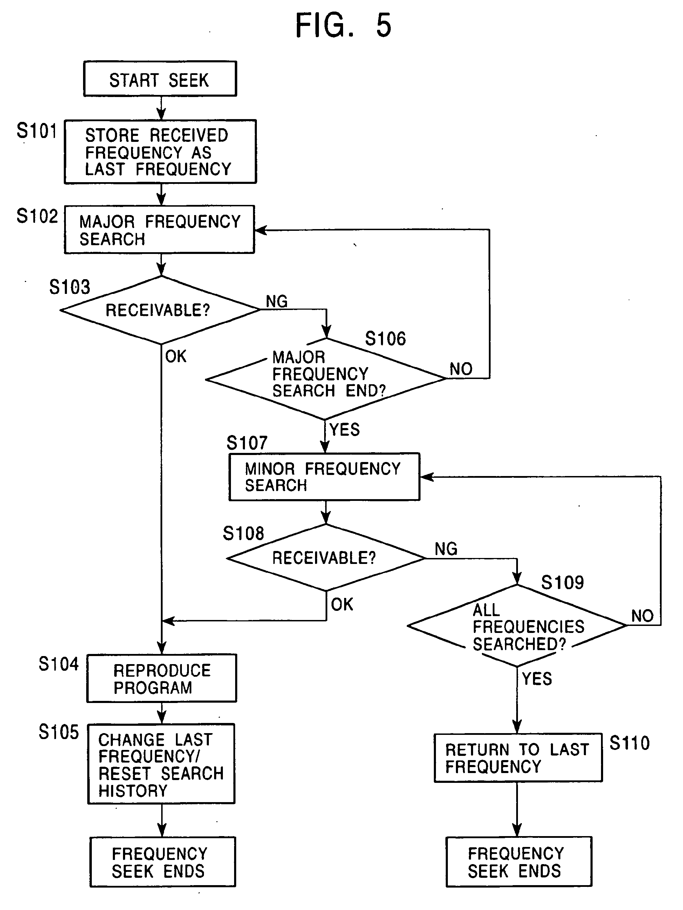

The frequency seeking operation described above is triggered when the user inputs, through the operation section 51, instructions as to whether the seeking is performed towards the higher frequency side or the lower frequency side starting from the frequency which is now being received. The microcomputer 50 sequentially alters the demultiplication factor which is to be set on the frequency divider 32 and stores the seeking history. A conventional seeking procedure will be described with reference to the flowchart shown in Fig. 5.

The microcomputer 50 stores major frequencies which are, for example, the frequencies actually used in the European area as the frequencies for DAB. When a seek start request is given through the operation section 51, the frequency which is being received is stored as the last frequency to be used as the reference or seek-start frequency from which the seek is to be commenced (Step S101). Then, the seeking operation proceeds to search for a major frequency which is closest to the seek-start frequency (Step S102).

During the frequency seeking operation, when an arbitrary request is input through the operation section 51, the frequency seeking operation is terminated and the frequency is set again to the last frequency. The microcomputer stores the searched frequencies as the seeking history. This seeking history is reset when the frequency seeking operation is over.

During the frequency seeking operation, the microcomputer 50 determines whether DAB signal is receivable at each of the set frequencies, based on, for example, the state of decoding informed to the microcomputer 50 by the DAB decoder 42 (Step S103). The microcomputer 50, upon determining that a DAB signal is receivable, stops the frequency seeking operation and starts to reproduce the broadcast program at this frequency (Step S104). In this state, the microcomputer 50 sets this frequency as the new last frequency (Step S105) and terminates the frequency seeking operation while resetting the seeking history. When the seeking operation is restarted, search is conducted for the next major frequency, using the new last frequency as the seek-start frequency. When Step S103 has determined that the signal is not receivable, the microcomputer 50 operates to update the seeking history and to continue the frequency seeking operation (Step S106).

If it is determined in Step S106 that all the major frequencies are not receivable, the seek program returns to the last frequency and starts the seeking operation to search for frequencies other than the major frequency, i.e., minor frequencies (Step S107). This seeking operation is performed in the same way as that for the seeking operation for major frequencies. Namely, whether the signal is receivable is determined for each of the successive minor frequencies (Step S108). If a minor frequency is found to be receivable, the seeking operation is stopped and the broadcast program is reproduced at this frequency in the step S104, followed by execution of the Step S105 which alters the last frequency and terminates the seeking operation while resetting the seeking history. If signal is not receivable in Step S108, the seeking operation is continued (Step S109).

If all the frequencies were not receivable through the frequency search executed in Step S109, the seek program returns to the last frequency from which the seeking operation was commenced (Step S110), whereby the frequency seeking operation is terminated and the seeking history is reset.

Thus, the conventional system implements a high frequency seeking speed by primarily searching major frequencies that have high probabilities of being received. In the conventional frequency seeking method, the last frequency from which the subsequent seek is to be commenced is newly set and the frequency seeking operation is terminated while resetting the seeking history, each time the seeking operation is stopped at a receivable frequency.

It is, however, conceivable that more frequencies including minor frequencies will be employed in future DAB system. The conventional seeking system, which alters the last frequency and resets the seeking history each time the seeking operation is stopped at one of two or more major frequencies, suffers from a problem in that only the major frequencies are searched out despite a repeated restarting of the seeking operation. In other words, minor frequencies are not searched at all.

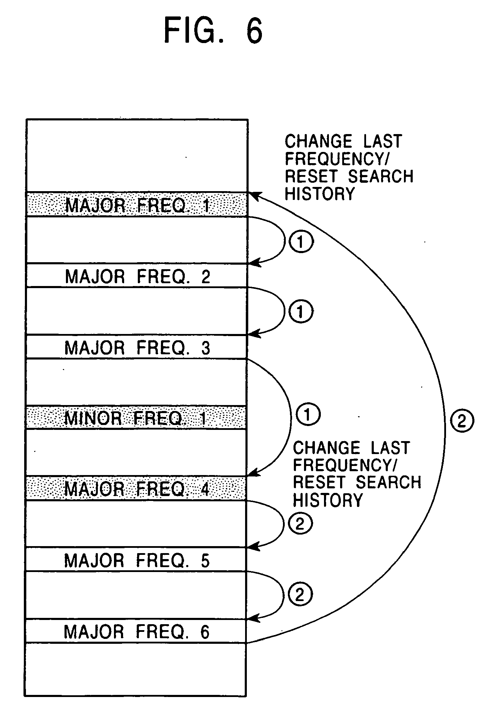

This problem will be described in more detail, with reference to Fig. 6. Referring to Fig. 6, it is assumed that a major frequency 1, a major frequency 4 and a minor frequency 1 are receivable. Numerals in circles show the serial of the successive seeking operations or sessions. According to the conventional seeking method, when the first seeking session is stopped at the major frequency 4, the last frequency from which the next seeking session is to be commenced is altered to the frequency 4 and, at the same time, the seeking history is reset. When the next or the second seeking session is started, the next receivable major frequency is searched, because the last frequency from which the seeking session is commenced has been changed and the seeking history has been reset. Therefore, the second seeking session is stopped at the major frequency 1.

When a subsequent seeking session is restarted, the seek is stopped again at the major frequency 4. Thus, the receivable minor frequency 1 is not searched at all.

An object of the present invention is to provide a receiver apparatus which does not alter the last frequency and which does not reset the seeking history when a frequency seeking operation is stopped at a receivable DAB frequency. As a result, a frequency that was once searched out in the preceding seeking session is excluded from the subsequent seek sessions until the frequency seeking operation is finished to find and test all the receivable frequencies. This allows all the frequencies including minor frequencies to be searched and tested even when there are two or more major frequencies.

Another object of the present invention is to provide a receiver apparatus in which the frequency that is being received is automatically set as a new last frequency, if no request is given for changing the receiving frequency within a predetermined time from the moment at which the seeking operation is stopped at a detected receivable frequency.

To these ends, according to the present invention, there is provided a receiver apparatus having searching means for searching a receivable frequency, comprising: first storage means for storing the last frequency that has been received until the searching is started; means for detecting continuation of the receiving operation; and first memory control means for holding the last frequency until the continuation of the receiving operation is detected.

With these features, when continuation of the receiving operation is detected, the last frequency that has been stored in the first storage means is rewritten by the first memory control means, so that, when the receiving is suspended after continuation and then restarted, undesirable repetition of the seeking operation starting from the initially-set last frequency is avoided.

The receiver apparatus further comprises: second storage means for storing major broadcasting frequencies; major frequency searching means for searching the major frequencies stored in the second storage means, using the last frequency as the seek-start frequency; and minor frequency searching means for searching for frequencies other than the major frequencies, when no continuously-received frequency has been detected.

With these features, the major frequency stored in the second storage means is preferentially searched by the major frequency searching means, thus allowing a quick searching operation.

The receiver apparatus further comprises: third storage means for storing receiving information obtained during the searching; and second memory control means for holding the receiving information stored in the third storage means, until the continuation of receiving operation is detected.

With these features, the third storage means stores receiving information, i.e., receiving history, in addition to the last frequency, so that all the frequencies can be searched even after a suspension of the seeking operation.

The receiver apparatus is arranged such that the means for detecting the continuation of receiving operation comprises: counting means for counting the time elapsed from the moment of receipt of broadcasting; and comparator means for comparing the output of the counting means with a predetermined value.

With these features, detection of continuation of receiving operation is automatically performed within a predetermined period of time by the cooperation between the counting means and the comparator means.

These and other objects, features and advantages of the present invention will be described in detail with reference to the accompanying drawings.

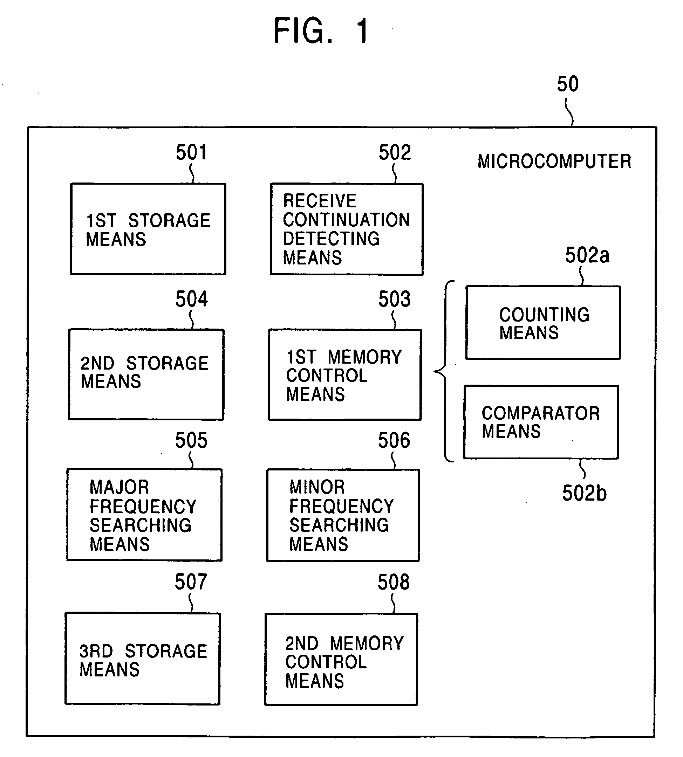

Fig. 1 is a block diagram showing the configuration of an embodiment of the receiver apparatus in accordance with the present invention;
Fig. 2 is a flowchart illustrative of the operation of the embodiment shown in Fig. 1;
Fig. 3 is an illustration of operation performed by the receiver apparatus of the present invention when there is a receivable minor frequency;
Fig. 4 is a block diagram of a conventional DAB receiver apparatus;
Fig. 5 is a flowchart illustrative of the operation of the conventional DAB receiver apparatus; and
Fig. 6 is an illustration of the operation performed by the conventional receiver apparatus when there is a receivable minor frequency.

An embodiment of the present invention will be described in detail with reference to the accompanying drawings.

General configuration of the receiver apparatus of this embodiment is similar to that of the conventional apparatus described before with reference to Fig. 5. The following description, therefore, will be focused mainly on the distinguishing features. In the foregoing description of the conventional apparatus, the microcomputer 50 has been described as being searching means. In the embodiment of the present invention which will now be described, the searching means implemented by the microcomputer has the following configuration.

### [1. Configuration of the embodiment]

More specifically, the microcomputer 50 incorporated in this embodiment implements searching means which searches for receivable frequencies. The searching means includes first storage means 501 for storing the last frequency that has been received till the start of the frequency seeking operation. The searching means also includes means 502 for detecting continuation of the receiving operation, and first memory control means 503 which holds the last frequency until the continuation of the receiving operation is detected.

The means 502 for detecting the continuation of receiving operation includes counting means 502a for measuring the time elapsed from the moment at which the receiving is started, and comparator means 502b which compares the output of the counting means 502a with a predetermined value.

The microcomputer 50 also has second storage means 504 for storing major frequencies used in the broadcasting, major frequency searching means 505 which starts seeking operation using the last frequency as a seek-start reference for searching the major frequencies stored in the second storage means 504, and minor frequency searching means which searches for frequencies other than the major frequencies when no major frequency continuously received has been found. The microcomputer 50 further has third storage means 507 for storing receiving information acquired in the course of the seeking operation, and second memory control means 508 which serves to hold the receiving information stored in the third storage means 507 until the continuation of receiving operation is detected.

The major frequency searching means 505 and the minor frequency searching means 506 sequentially search the major frequencies and minor frequencies, respectively, coming from different broadcasting stations. When a major frequency or a minor frequency having an electric field intensity greater than a predetermined level is detected through the search, the major or minor frequency searching means stops the searching operation to cause the receiver apparatus to receive the signals from the broadcasting station which transmits the signals at the detected frequency.

### [Operation of the embodiment]

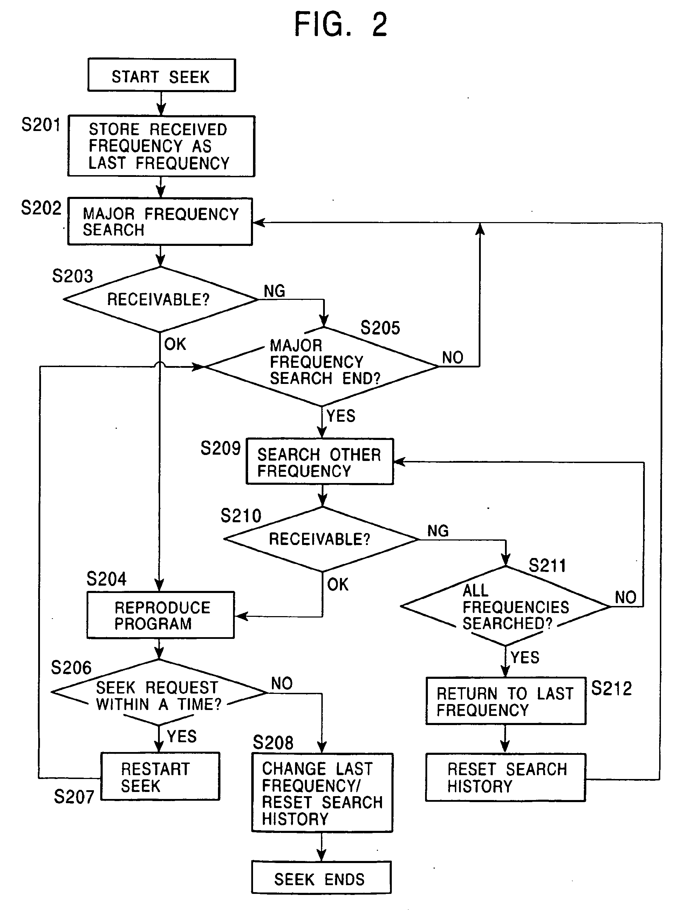

The operation of the embodiment having the described configuration will now be explained with reference to a flowchart shown in Fig. 2.

When a frequency seek request is given through the operating section 51, the microcomputer 50 operates so that the frequency which is being received is stored as the last frequency in the first storage means 501 (Step S201). Thereafter, as in the case of the conventional frequency seeking method, the major frequencies that have been stored in the second storage means 504 are preferentially searched by the major frequency searching means 505 (Step S202). Whether a DAB signal is receivable is determined for each of the searched major frequencies based on the state of decoding sent from the DAB decoder 42 (Step S203).

If the Step S203 has determined that a DAB signal of a certain frequency is receivable, the major frequency searching means 505 stops the frequency seeking operation to allow the receiver apparatus to reproduce the broadcast program (Step S204) at this frequency. In this embodiment, however, the last frequency is maintained without change, and the seeking history also is maintained in the third storage means 507, despite the stopping of the seeking operation. Conversely, if the major frequency searching means 505 has determined in the Step S203 that no DAB signal is receivable, the frequency seeking operation is continued (Step S205).

During reproduction of the broadcast program, the counting means 502a of the receiving continuation detecting means 502 operates to measure the time from the moment at which the receiving of the broadcast program is commenced, and the comparator means 502 b operates to determine whether there is a request for restarting the seeking operation entered within a predetermined period of time (Step S206). If such a request has been received within the time, the frequency seeking operation is restarted (Step S207). In this embodiment, the last frequency which is used as the seek-start reference frequency is not changed, and the seeking history stored in the third storage means 507 is not reset, so that the frequency or frequencies that have already been searched in the Step S202 by the major frequency searching means 505 are excluded from the seeking object.

The restarted frequency seeking operation is suspended if any request is given by the user through the operating section 51. When the frequency seeking operation is suspended, the seek is reset to the original last frequency that was initially set and that has been stored in the first storage means 501, rather than to the frequency of the reproduced program.

Conversely, if no request for restarting the frequency seeking operation is received in Step S206, the first memory control means 503 operates to set the frequency which is being received as a new last frequency (Step S208). At the same time, the second memory control means 508 operates to reset the seeking history stored in the third storage means 507. The major frequency searching means 505, when starting again the frequency seeking operation, commences the searching for the major frequencies using the above-mentioned new last frequency as the seek-start reference frequency. Thereafter, when the frequency seeking operation is stopped by any request entered through the operating section 51, the seeking program is returned to the new last frequency rather than to the original last frequency that was set initially when the seeking operation was started for the first time, and then the frequency setting operation is performed.

The major frequency searching means 505 sequentially searches for the major frequencies to find any receivable major frequency and, when no receivable major frequency has been found until the search is over for all the major frequencies in Step S205, the seek program returns to the last frequency, and the seeking operation is started to search for minor frequencies by means of the minor frequency searching means 506 (Step S209). Whether the signal is receivable is determined at each of the successive minor frequency (Step S210). If the minor frequency searching means 506 has found a minor frequency that is receivable, the frequency seeking operation is suspended and the broadcast program of this frequency is reproduced in Step S204.

As in the case of the search through the major frequencies, if a frequency seeking restarting request is received within a predetermined period of time in Step S206, the frequency seeking operation is restarted in Step S207 without altering the last frequency and without resetting the seeking history. Conversely, if no seek restart request is received within the predetermined time, the process proceeds to Step S208 in which the frequency which is being received is set in the first storage means 501 as the new last frequency, by the operation of the first memory control means 503. At the same time, the second memory control means 508 operates to reset the seeking history that has been stored in the third storage means 507.

In Step S211, if the frequency seeking operation has been finished for all the frequencies, the seek program returns to the last frequency (Step S212). In this step, the seeking history that has been stored in the third storage means 507 is reset by the second memory control means 508. If the DAB is not receivable at the last frequency, the seeking operation is continued so that the step S202 is executed to search again to find any major frequency that is receivable.

This seeking operation is finished when the seeking operation is stopped and returned to the last frequency, in response to any other request given through the operating section 51 during the seeking operation. Alternatively, the seeking operation is finished in response to the updating of the last frequency in Step S208 which is executed when no seek restarting request is received in the step S206 after the suspension of the seeking operation at a detected receivable DAB frequency. The seeking history is reset in each of these two cases of finishing the seeking operation.

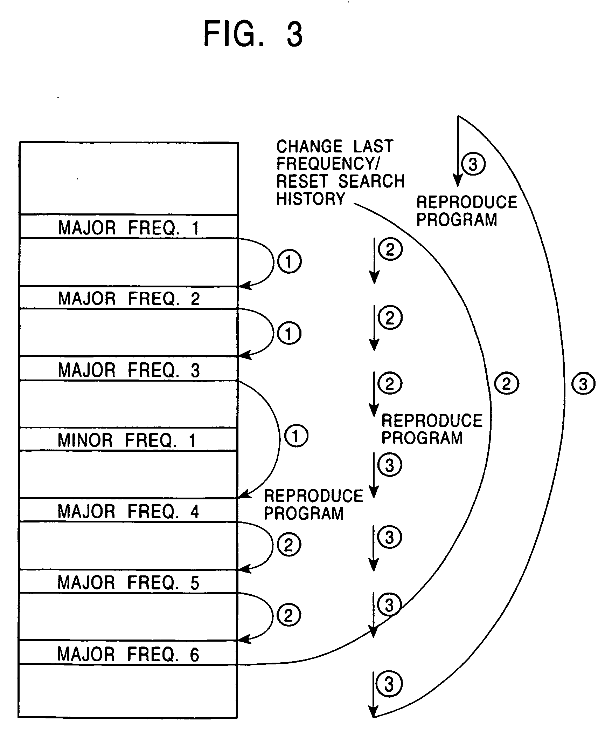

Fig. 3 shows an example of the frequency seeking operation performed in accordance with the present invention. It is assumed that DAB is receivable at a major frequency 1, a major frequency 4 and a minor frequency 1. Numerals appearing in circles indicate the serial numbers of the seeking sessions.

In accordance with the present invention, when the first frequency seeking session is stopped at the receivable major frequency 4, the last frequency that was set initially to the major frequency 1 is maintained without change, and the seeking history is also maintained without being reset. When the seeking operation is restarted, i.e., when the second session of the seeking operation is started, the search is made only for the receivable frequencies that have not yet been searched. Since in this case there is no other receivable major frequency, the seek returns to the major frequency that is the last frequency. In accordance with the present invention, reproduction of program at this last frequency is not conducted but the seeking operation is continued to search for receivable minor frequency by the operation of the minor frequency searching means. Consequently, the seeking operation is stopped at the minor frequency 1 which is receivable. When a further seeking operation is conducted, the seek program finally returns to the major frequency 1 which is the last frequency, since there is no further receivable frequency. At this time, the searching history is reset, and the broadcast program at this major frequency 1 is executed.

### [3. Advantages of the embodiment]

As will be understood from the foregoing description, in the illustrated embodiment, the alteration of the last frequency as the reference for the seeking operation nor the resetting of the seeking history is conducted when the seeking operation is suspended to reproduce a DAB program at a receivable frequency. In other words, any frequency which was searched and tested in the previous session of the seeking operation is excluded from the objects of the search, until the search is finished for all the frequencies. It is therefore possible to search and test all the frequencies without fail, even when two or more receivable major frequencies exist.

If no seek restarting request is given within a predetermined period of time from a moment at which the seek is stopped to reproduce a program at a detected receivable frequency, the last frequency to be used as a seek-start reference for the seeking operation is automatically updated and the seeking history also is reset. When a next frequency seeking request is received, the seeking operation is executed to search for receivable frequencies, using the updated last frequency as the reference.

As will be understood from the foregoing description, in accordance with the present invention, it is possible to search out all the frequencies, and to automatically update the last frequency to enable searching for other frequencies even after a suspension of the seeking operation. Thus, the present invention provides a receiver apparatus which excels in the seeking performance.

Although the invention has been described through illustration of its preferred form, it is to be understood that the described embodiment is only illustrative and various changes and modifications may be imparted thereto without departing from the scope of the present invention which is limited solely by the appended claims.

## Claims

1. Frequency searching method for a receiver apparatus, comprising the steps of
storing a last frequency received before searching,
searching a receivable frequency among major frequencies stored in a storage means,
sequentially searching for receivable minor frequencies other than the major frequencies after all major frequencies have been searched,
storing the searched frequencies to a searching history,
reproducing a broadcast program at a detected receivable frequency, said method being **characterized by** the steps:
starting counting means for measuring the time from the beginning of said receiving of said broadcast program;
restarting said searching, on a request by a user instruction within a predetermined value of said counting means, wherein frequencies stored in said searching history are excluded in said restarted searching;
returning to the last frequency and resetting the search history, when all frequencies have been searched;
after a receivable frequency is found, altering the last frequency to the receivable frequency and resetting the searching history when no restart of searching is requested within a predetermined time corresponding to the predetermined value of the counting means.

2. Method according to claim 1, comprising further starting said searching for receivable minor frequencies from said last frequency on completion of searching for all the major frequencies.

3. Method according to claim 1 or 2, comprising further on a respective user request suspending said searching, receiving said last frequency, and reproducing a broadcast program at said last frequency.

4. Method according to one of the proceeding claims, comprising further returning to said last frequency and searching any one receivable major frequencies after searching all frequencies.

5. Method according to one of the proceeding claims, wherein said receiver apparatus is a Digital Audio Broadcasting (DAB) receiver.

6. A receiver apparatus having searching means for searching a receivable frequency, comprising:
first storage means (501) for storing a last frequency received immediately before start of searching;
second storage means (504) for storing major broadcasting frequencies;
third storage means (507) for storing receiving information obtained during said searching as a searching history;
**characterized by**
major frequency searching means (505) for searching major frequencies stored in said second storage means, said major frequency searching means (505) adapted to use said last frequency as a reference frequency and to exclude the frequencies stored in the searching history from search;
minor frequency searching means (506) for searching for a frequency other than said major frequencies when all major frequencies have been searched, said minor frequency searching means (506) adapted to start with said last frequency and to exclude the frequencies stored in the searching history from search;
detecting means (502) arranged to detect continuation of the receiving of a broadcast program, and comprising counting means (502a) for counting the time elapsed from the beginning of receiving of the broadcast program and comparator means (502b) comparing the output of said counting means with a predetermined value, wherein the comparator means (502b) is arranged to determine whether a request for restart of a frequency searching operation is entered by a user instruction within a predetermined time corresponding to the predetermined value of the counting means;
first memory control means (503) arranged to hold the last frequency stored in the first storage means (501), and to set the received frequency as a new last frequency when no searching restart request is received within the predetermined time and thus continuation of the receiving is detected;
second memory control means (508) arranged to hold the searching history stored in said third storage means, and to reset the searching history when no searching restart request is received within the predetermined time and thus continuation of the receiving is detected or when all frequencies have been searched.

7. Receiver apparatus according to claim 6, wherein said receiver apparatus is a Digital Audio Broadcasting (DAB) receiver.

## Patentansprüche

1. Frequenzsuchverfahren für ein Empfangsgerät, die Schritte enthaltend:
Speichern einer letzten Frequenz, die vor der Suche empfangen worden ist,
Suchen nach einer empfangbaren Frequenz unter Hauptfrequenzen, die in einem Speichermittel gespeichert sind,
folgendes Suchen nach empfangbaren Nebenfrequenzen abweichend von den Hauptfrequenzen, nachdem alle Hauptfrequenzen durchsucht worden sind,
Speichern der durchsuchten Frequenzen in einer Suchhistorie,
Wiedergeben eines Rundfunkprogramms, bei einer aufgespürten empfangbaren Frequenz,
wobei das Verfahren **gekennzeichnet ist durch** die Schritte:
Starten eines Zählmittels zum Messen der Zeit ab dem Beginn des Empfangs des Rundfunkprogramms;
Neustart der Suche auf eine Anforderung **durch** einen Benutzerbefehl innerhalb eines vorgegebenen Wertes des Zählmittels, wobei in der Suchhistorie gespeicherte Frequenzen von der neu gestarteten Suche ausgeschlossen sind;
Rückkehr zu der letzten Frequenz und Zurücksetzten der Suchhistorie, wenn alle Frequenzen durchsucht worden sind;
nachdem eine empfangbare Frequenz gefunden ist, Ändern der letzten Frequenz zu der empfangbaren Frequenz und Zurücksetzen der Suchhistorie, wenn kein Neustart der Suche innerhalb einer vorgegebenen Zeit, die dem vorgegebenen Wert des Zählmittels entspricht, angefordert wird.

2. Verfahren nach Anspruch 1, ferner das Starten der Suche nach empfangbaren Nebenfrequenzen von der letzten Frequenz bei Abschluss der Suche nach allen Hauptfrequenzen enthaltend.

3. Verfahren nach Anspruch 1 oder 2, ferner auf eine entsprechende Benutzeranforderung hin das Unterbrechen der Suche, das Empfangen der letzten Frequenz und das Wiedergeben eines Rundfunkprogramms bei der letzten Frequenz enthaltend.

4. Verfahren nach einem der vorangehenden Ansprüche, ferner das Zurückkehren zu der letzten Frequenz und das Suchen irgendeiner empfangbaren Hauptfrequenz nach dem Durchsuchen aller Frequenzen enthaltend.

5. Verfahren nach einem der vorangehenden Ansprüche, wobei das Empfangsgerät ein Digital-Audiorundfunk-(DAB)-Empfänger ist.

6. Empfangsgerät mit Sucheinrichtung zum Suchen einer empfangbaren Frequenz enthaltend:
ein erstes Speichermittel (501) zum Speichern einer letzten Frequenz, die unmittelbar vor dem Start der Suche empfangen wird;
ein zweites Speichermittel (504) zum Speichern von Hauptrundfunkfrequenzen;
ein drittes Speichermittel (507) zum Speichern von Empfangsinformationen, die während der Suche erlangt werden, als Suchhistorie;
**gekennzeichnet durch**
ein Hauptfrequenzsuchmittel (505) zum Durchsuchen von Hauptfrequenzen, die in dem zweiten Speichermittel gespeichert sind, wobei das Hauptfrequenzsuchmittel (505) dafür ausgelegt ist, die letzte Frequenz als Referenzfrequenz zu verwenden und die in der Suchhistorie gespeicherten Frequenzen von der Suche auszuschließen;
ein Nebenfrequenzsuchmittel (506) zum Suchen einer Frequenz abweichend von den Hauptfrequenzen, wenn alle Hauptfrequenzen durchsucht worden sind, wobei das Nebenfrequenzsuchmittel (506) dafür ausgelegt ist, mit der letzten Frequenz zu beginnen und die in der Suchhistorie gespeicherten Frequenzen von der Suche auszuschließen;
ein Erkennungsmittel (502), das dafür ausgelegt ist, eine Fortsetzung des Empfangs eines Rundfunkprogrammes zu erkennen, und ein Zählmittel (502a) zum Zählen der seit dem Beginn des Empfangs eines Rundfunkprogramms verstrichenen Zeit und ein Komparatormittel (502b) zum Vergleichen der Ausgabe des Zählmittels mit einem vorgegebenen Wert enthaltend, wobei das Komparatormittel (502b) dafür ausgelegt ist, zu bestimmen, ob eine Anforderung zum Neustart einer Frequenzsuchoperation mittels einer Benutzeranweisung innerhalb einer vorgegebenen Zeitspanne, die dem vorgegebenen Wert des Zählmittels entspricht, eingegeben wird;
ein erstes Speichersteuermittel (503), das dafür ausgelegt ist, die im ersten Speichermittel (501) gespeicherte letzte Frequenz zu halten und die empfangene Frequenz als neue letzte Frequenz zu setzen, wenn keine Suchneustartanfrage innerhalb der vorgegebenen Zeitspanne empfangen wird und somit die Fortsetzung des Empfangs erkannt wird;
ein zweites Speichersteuermittel (508), das dafür ausgelegt ist, die in dem dritten Speichermittel gespeicherte Suchhistorie zu halten und die Suchhistorie zurückzusetzen, wenn keine Suchneustartanforderung innerhalb der vorgegebenen Zeitspanne empfangen wird und somit die Fortsetzung des Empfangs erkannt wird, oder wenn alle Frequenzen durchsucht worden sind.

7. Empfangsgerät nach Anspruch 6, wobei das Empfangsgerät ein Digital-Audiorundfunk-(DAB)-Empfänger ist.

## Revendications

1. Procédé de recherche de fréquences destiné à un appareil récepteur, comprenant les étapes
de mémorisation d'une dernière fréquence reçue avant une recherche,
de recherche d'une fréquence pouvant être reçue parmi des fréquences majeures mémorisées dans un moyen de mémorisation,
de recherche de manière séquentielle de fréquences mineures pouvant être reçues autres que les fréquences majeures après que toutes les fréquences majeures ont été recherchées,
de mémorisation des fréquences recherchées dans un historique de recherche,
de reproduction d'un programme de diffusion au niveau d'une fréquence pouvant être reçue détectée,
ledit procédé étant **caractérisé par** les étapes :
de démarrage d'un moyen de comptage destiné à mesurer le temps écoulé depuis le début de ladite réception dudit programme de diffusion ;
de redémarrage de ladite recherche, sur demande d'une instruction d'utilisateur correspondant à une valeur prédéterminée dudit moyen de comptage, où des fréquences mémorisées dans ledit historique de recherche sont exclues de ladite recherche redémarrée ;
de retour à la dernière fréquence et de réinitialisation de l'historique de recherche, lorsque toutes les fréquences ont été recherchées ;
après qu'une fréquence pouvant être reçue est trouvée, de modification de la dernière fréquence en la fréquence pouvant être reçue et de réinitialisation de l'historique de recherche lorsqu'aucun redémarrage de recherche n'est demandé dans un intervalle de temps prédéterminé correspondant à la valeur prédéterminée du moyen de comptage.

2. Procédé selon la revendication 1, comprenant en outre un démarrage de ladite recherche de fréquences mineures pouvant être reçues à partir de ladite dernière fréquence à l'achèvement d'une recherche de toutes fréquences majeures.

3. Procédé selon la revendication 1 ou 2, comprenant en outre, sur demande d'utilisateur respective, une mise en suspens de ladite recherche, une réception de ladite dernière fréquence, et une reproduction d'un programme de diffusion au niveau de ladite dernière fréquence.

4. Procédé selon l'une des revendications précédentes, comprenant en outre un retour à ladite dernière fréquence et une recherche de toutes les fréquences majeures pouvant être reçues après recherche de toutes les fréquences.

5. Procédé selon l'une des revendications précédentes, dans lequel ledit appareil récepteur est un récepteur de diffusion audionumérique (DAB).

6. Appareil récepteur comportant un moyen de recherche destiné à rechercher une fréquence pouvant être reçue, comprenant :
un premier moyen de mémorisation (501) destiné à mémoriser une dernière fréquence reçue immédiatement avant le début d'une recherche ;
un deuxième moyen de mémorisation (504) destiné à mémoriser des fréquences de diffusion majeures ;
un troisième moyen de mémorisation (507) destiné à mémoriser des informations de réception obtenues au cours de ladite recherche en tant qu'historique de recherche ;
**caractérisé par**
un moyen de recherche de fréquences majeures (505) destiné à rechercher des fréquences majeures mémorisées dans ledit deuxième moyen de mémorisation, ledit moyen de recherche de fréquences majeures (505) étant conçu pour utiliser ladite dernière fréquence en tant que fréquence de référence et pour exclure de la recherche les fréquences mémorisées dans l'historique de recherche ;
un moyen de recherche de fréquences mineures (506) destiné à rechercher une fréquence autre que lesdites fréquences majeures lorsque toutes les fréquences majeures ont été recherchées, ledit moyen de recherche de fréquences mineures (506) étant conçu pour démarrer avec ladite dernière fréquence et pour exclure de la recherche les fréquences mémorisées dans l'historique de recherche ;
un moyen de détection (502) conçu pour détecter une continuité de la réception d'un programme de diffusion, et comprenant un moyen de comptage (502a) destiné à compter le temps écoulé depuis le début d'une réception du programme de diffusion et un moyen de comparaison (502b) comparant le résultat dudit moyen de comptage à une valeur prédéterminée, où le moyen de comparaison (502b) est conçu pour déterminer si une demande de redémarrage d'une opération de recherche de fréquences est entrée par une instruction d'utilisateur dans un intervalle de temps prédéterminé correspondant à la valeur prédéterminée du moyen de comptage ;
un premier moyen de contrôle de mémoire (503) conçu pour conserver la dernière fréquence mémorisée dans le premier moyen de mémorisation (501), et pour établir la fréquence reçue en tant que nouvelle dernière fréquence lorsqu'aucune demande de redémarrage de recherche n'est reçue dans l'intervalle de temps prédéterminé et que, par conséquent, une continuité de la réception est détectée ;
un deuxième moyen de contrôle de mémoire (508) conçu pour conserver l'historique de recherche mémorisé dans ledit troisième moyen de mémorisation, et pour réinitialiser l'historique de recherche lorsqu'aucune demande de redémarrage de recherche n'est reçue dans l'intervalle de temps prédéterminé et que, par conséquent, une continuité de la réception est détectée ou lorsque toutes les fréquences ont été recherchées.

7. Appareil récepteur selon la revendication 6, où ledit appareil récepteur est un récepteur de diffusion audionumérique (DAB).
